**Europäisches Patentamt**

**European Patent Office**

**Office européen des brevets**

(19)

(11) Publication number : **0 303 235 B1**

# (12) EUROPEAN PATENT SPECIFICATION

(45) Date of publication of patent specification :
**17.07.91 Bulletin 91/29**

(51) Int. Cl.⁵ : **H01R 13/703**

(21) Application number : **88112947.2**

(22) Date of filing : **09.08.88**

(54) **Device for detecting placement of electrical connector terminal.**

(30) Priority : **10.08.87 JP 123056/87 U**

(43) Date of publication of application :
**15.02.89 Bulletin 89/07**

(45) Publication of the grant of the patent :
**17.07.91 Bulletin 91/29**

(84) Designated Contracting States :
**DE FR GB**

(56) References cited :
DE-A- 2 148 782
GB-A- 1 450 004
US-A- 3 196 424
US-A- 3 960 428
US-A- 4 658 212

(73) Proprietor : **Sumitomo Wiring Systems, Ltd.**
**1-14, Nishisuehirocho**
**Yokkaichi-shi Mie-ken (JP)**

(72) Inventor : **Ohno, Kengo**
**Higashi Haitsu 202, 9-16**
**Saiwai-cho, Yokkaichi City, Mie 510 (JP)**

(74) Representative : **Kuhnen, Wacker & Partner**
**Schneggstrasse 3-5 Postfach 1553**
**W-8050 Freising (DE)**

## Description

The present invention relates to a device for detecting the correct placement of an electrical terminal in a cavity of an electrical connector housing, according to the pre-characterizing part of claim 1.

Conventional terminal-lock detectors which detect incomplete terminal engagement into a cavity of an electrical connector housing are widely known. Also described are cavity identifiers which respective cavity in a connector housing is either electrically detected or indicated by light beams for a specific terminal to be inserted.

US-A-4,214,801 shows a fuse holder with insertion ramp in which the fuse holder is inserted into the terminal block and has an opening therein for receiving a protrusion extending into the passage. Fig. 4, of US-A-4,214,801 is directed toward the combination of an opening 28 and a ramp 210 in fuse holder 20 which is designed to receive a protrusion 13 from terminal blocs 10.

US-A-4,030,029 discloses lamps for illuminating the second connector cavity. In the harness assembly test system of US-A-4,030,029 an indication is provided at the second place which corresponds to the first place at which sequencing is stopped. In the preferred embodiment of this reference, a separate lamp is used to mark every second place. The lamps at the second place may be arranged in a patter similar to the pin pattern of the conductor, if a number of conductor wires are to be connected to a single multiple pin connector unit (refer to Fig. 1 of US-A-4,030,029).

US-A-4,462,155 discloses a pin locator in which light emitting diodes (LEDs) are in an array that represents the physical arrangement of the element insertion locations in a cable connector. The illuminated LED in the array indicates the location the element in contact with the grounded element insertion tool should be inserted in the cable connector. (refer to Fig. 1 and Fig. 2 of US-A-4,462,155).

US-A-4,658,212 discloses a connector terminal examination device with an examination head having a plurality of probes projected forwardly therefrom. The probe has a front portion and a rear probe portion slidably received in a metallic tube and independently biased forwardly leaving a predetermined gap between the probe portion when they are freed. The front probe portion is adapted to be moved into the metallic tube so as to make electrical contact with the rear probe portion which is electrically insulated from the metallic tube. During the examination the rear probe is pressed by a corresponding terminal of the connector.

DE-A-2 148 782, which is the nearest prior art, shows a multi-pole connector system for avoiding poor electrical contact of loss of contact, respectively, when a male connector being inserted in a female connector (both being multi-poled) becomes loose during subsequent use. For this purpose, some of the poles or terminals, respectively, at the male connector are shorter than the remaining ones, said shorter terminals are preferrably arranged at the periphery of the mult-pole connector, so that upon initial disconnection of male and female connector, the shorther terminals come out of engagement with the respective female terminals, before the remaining longer terminals come out of contact, and by means of disengagement of the shorter terminals, it is possible to start indication means or alarm means, respectively, indicating that the male connector is in the process of disengaging the female connector. DE-A-2 148 782 is especially directed to connecting operations in assembling electrical wires into a wiring harness of motor vehicles.

GB-A-1 450 004 shows an electrical connector assembly being (with respect to the object) very similar to that of DE-A-2 148 782, i.e. means are provided for giving an alarm signal, when a male connector is not in proper contact with a female connector or is starting to get loose from said female connector, respectively.

In the light of this it is the primary problem underlying the present invention to have a possibility to connect a plurality of electrical wires easily and correctly with an electrical connector housing such that each electrical terminal is identically placed in a respective cavity of the connector housing with a complete degree of insertion, which prevents withdrawal of the electric terminal out of a cavity.

Solution of this problem is achieved by the characterizing features of claim 1.

The device of the present invention finds broad applications in making connection of a plurality of electrical lead wires to an electrical connector housing where many connection cavities are located in a plurality of rows and columns.

Wire connecting operation in assembling electrical wires into a wiring harness of motor vehicle provides a typical field of application of the detection device of the present invention.

The present invention provides an improved detection device for an electrical terminal in a connector housing in such a way that its identical placement in a correct and specific cavity of an electrical connector housing is confirmed, while complete insertion of the terminal and resulting stable lock within the cavity are both assured.

The following is a description of preferred embodiment of the invention, taken in conjunction with the accompanying drawings, in which :

Fig. 1 to Fig. 3 show a mechanism of the detection device of the present invention used for cavity identification and lock confirmation of an electrical terminal in a passway of a cavity of an electrical connector housing ; and

Fig. 4 and Fig. 5 show a conventional resilient locking arm structure used for preventing withdrawal of the inserted electrical terminal out of the cavity of the electrical connector housing.

The detection device of the present invention is composed of a cylindrical case 1 of electro-conductive metallic material, a contact sensor probe 2 and an electrical contact member 3. To the cylindrical metallic case 1 there is attached a first electrical circuit 4 consisting of a an indication lamp 9a and an electric power source 10.

One end 5a of a second electrical circuit 5 is attached to the electrical contact member 3 at its projecting end portion 3a which is electrically isolated from case cylinder 1 by an insulating material 7, while the other circuit end 5b is connected to the electrical power source 10 through another indication lamp 9b which is in an electrically parallel way to the first electrical circuit 9a.

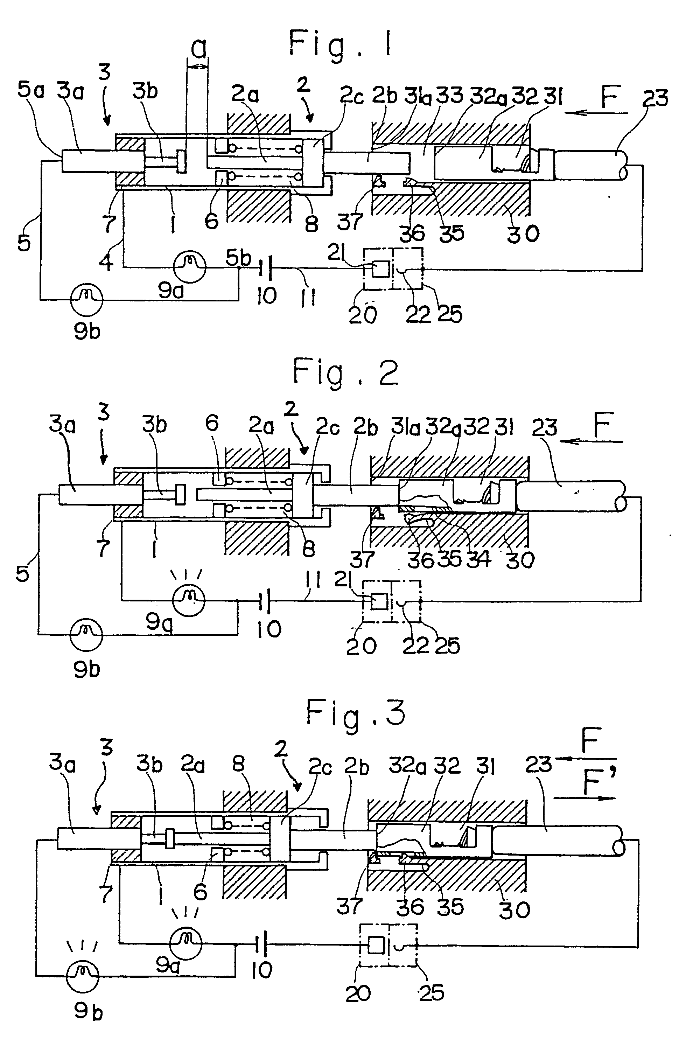

The contact sensor probe, 2 consists of : a cylindrical bar having two contact spindles 2a, 2b which share a common longitudinal axis, a flange 2c, a bearing 6 of thrust type and a coil spring 8 which is placed between the flange 2c and the bearing 6, when the electrical contact member 3 is placed in the case cylinder 1. As can be seen in Fig. 1 through Fig. 3 the contact spindles 2a, 2b are maintained in the case cylinder 1 through the bearing 6 and the flange 2c, both of which face with the inner wall of the case cylinder 1 and share their longitudinal axes with that of the case 1.

The second spindle 2b is projecting outside of the opening of the case cylinder 1 facing an electrical terminal 32 in a cavity 31 of a connector housing 30.

The terminal is subjected both to identification of its correct placement and to confirmational testing for its state of locking within a specific cavity 31 of the electrical connector housing 30.

In a general practice of making a wiring harness assembly, electrical lead wires 23 having electrical terminals of both ends are placed on an assembling table or board on which a wiring chart is attached. According to the chart, there are attached to either of the top or rear surface of the table components of the subject wiring harness such as electrical connectors, switches, fuse-holders, and wire junction boxes. It should be noted that one end portion of each of the electrical lead wires 23 has usually been connected to a receiving terminal of the first connector housing 20 at its specified cavity 21 of the housing, since a unitary set of wires are used in common for various kinds of wiring assemblies independent of differences between car models. In a practical wiring operation, therefore, its is required that a simple and accurate method of identification of the mating cavity in an electrical connector is used and that its confirmational testing is carried out in order to prove that a stable and correct terminal connection has been made.

Fig. 1 shows a cross sectional view of the detection device of the present invention wherein the second contact spindle 2b of the device is facing an electrical terminal 32 attached to a free end portion of an electrical lead wire 23 which is inserted into the mating cavity 31 of the second electrical connector housing 30 which in turn is placed on the top of the wiring assembly board.

In Fig. 1 the first contact spindle 2a of the contact sensor probe 2 is placed apart from the contact surface of the counter-facing cylindrical projecting end 3a with a distance $\underline{a}$. When the electrical terminal 32 proceeds in a direction $\underline{F}$, its head portion touches the right side end surface of the second contact spindle 2b and continues to move in the same direction as insertion proceeds until it comes to a stopper 34 at the end of the passway 33 of the terminal 32 in the cavity 31 of the connector housing 30. During this terminal insertion process, the spindles 2a 2b of the contact sensor probe 2 are shifted in direction $\underline{F}$ while the coil spring 8 is compressed by the flange 2c as they are shifted until it touches the end surface of the contact point 3b of the contact member 3 with indication signals at lamp 9a.

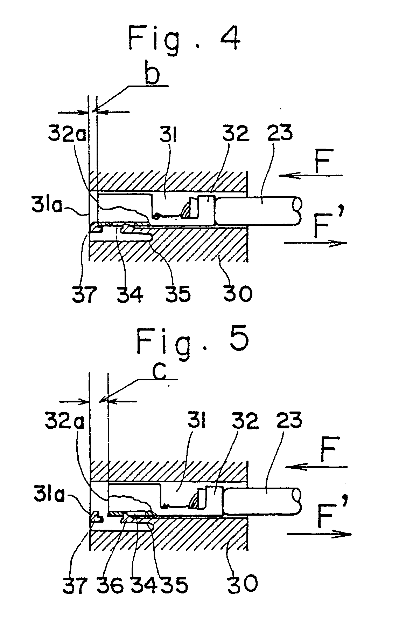

Methods of locking an electrical terminal are widely known. A typical example is shown in Fig. 4 and Fig. 5. The terminal 32 of a male structure has an opening 34 in its bottom portion and is mated with a projection 36 located on a flexible resilient arm structure 35 which holds the terminal 32 upwardly during the process of insertion through the passway 33 of the cavity 31.

When the projection 36 is in mating engagement with the opening 34 of the terminal 31, the arm comes down to original (horizontal) direction and the terminal 32 still continues to be shifted in the same directon $\underline{F}$ until its left-side-bottom corner is hold by a recess of a stopper 37. As illustrated in Fig. 4 and Fig. 5, the terminal 32 is locked within the cavity 31 and thus its withdrawal to the direction $\underline{F}'$ is prohibited.

According to the above description it is understood that the terminal can proceed after mating of the projection 36 with the terminal opening 34 in a distance of c-b where $\underline{c}$ is an initial lock distance which means a gap between the opening 34 in the opposite side of the passway 33 and the front surface 32a of the electrical terminal 32 when the projection 36 is first mated with the opening 34 of the terminal 31 ; and where $\underline{b}$ is the final lock distance which means a clearance between the opening 33a of the passway 33 and the front surface 32a of the terminal 32 when the terminal 32 is held by the stopper 37. Further the lengthwise distance $\underline{d}$ of the opening 34 of the electrical terminal 31 is generaly called "a mating distance" and is designed to be larger than $\underline{b}$ which is almost equal to the width of the stopper 37. These structural design elements including sensor contact clearance a, initial lock position b, final lock position c, and mating distance d are essential elements for determining range of detection of the detection device of the present invention.

For instance an indication of stable lock is achieved by illuminating the indication lamp 9b of the second detection circuit 5 when the front surface 32a of the terminal 32 is located within a range of c-b taken from the opening 33a of the passway 33 of the cavity 31 where sensor contact clearance a continues to be zero from initial to the final lock position. This design principle can be widely used in electrical connecting operation for detecting stable lock of an electrical terminal in a passway of a connector cavity.

The process of detecting identification of cavity in the connector housing and testing of stable locking of the inserted electrical terminal is described in more detail.

To each cavity 31 of the electrical connector housing 30 there is attached a corresponding detection device of the present invention in a way that the longitudinal axes of the contact sensor probe 2 and the electrical contact member 3 are common and said common axis is shared with the longitudinal axis of the electrical terminal 32 to be inserted.

The front surface of the second contact spindle 2b is located inside of the passway 33 of the cavity 31 of the connector housing 30 with a distance X along the longitudinal axis of the passway 33. The distance X is designed to satisfy the following equations :

$$a+b < X \leq c \quad \text{---------} \quad (1)$$

$$c < d \quad \text{---------} \quad (2)$$

where    "a" is sensor contact clearance
           "b" is stop clearance
           "c" is initial lock distance
           "d" is mating distance

As the electrical terminal 32 is inserted into the cavity 31 of the second connector housing 30 along the passway 33 in a way shown in Fig. 1 to Fig. 3, the front end of the electric terminal touches the counterfacing surface of the second contact spindle 2b (refer to Fig. 2). Then the first electrical circuit 4 is closed through the contact sensor probe 2, coil spring 8, bearing 6, case cylinder 1, and the indication lamp 9a resulting in illumination of the lamp which is indicative of the correct placement of the electrical terminal.

Further insertion of the electric terminal 32 causes continuous shift of the contact spindles 2a and 2b in the direction of F followed by compression of the coil spring 8.

When the surface of the first contact spindle moves the distance of c-b beyond the initial mating point of the projection 36 and the opening 34 the axial contact clearance a between the two spindles 2a and 2b becomes zero which means the second contact spindle 2a makes a contact to the inner contact point 3b causing another indication lamp 9b to be lighted. Illumination of the lamp 9b indicates that the insertion of the electrical terminal 32 into the cavity 31 of the second connector housing 30 is completed.

As described in detail, correct placement of inserted electrical terminal and stable lock of the terminal in the corresponding cavity of the connector housing are proofed without difficulty by using the detection device of the present invention. It should be understood the many applications can be made based on the structural design concepts of the present invention within the scope of the claims.

In summary, the device of the present invention discloses —among others— the following essential features :

(1) Placement of an electrical terminal in the cavity with a predetermined address is detected by making a contact of the electric terminal in the cavity to a contact sensor probe located in an opposite side of the passway of the relevant cavity of the connector housing.

(2) A locking mechanism is provided in such a way that an opening on the bottom surface of the electrical terminal will make on locking engagement with a projection of a resilient arm in a cavity floor of the terminal passway.

(3) When the electrical terminal is inserted deep enough into the cavity and the opening in the bottom first meet with the lock projection, the front surface of the terminal makes a contact to the contact sensor probe.

(4) The terminal continues to move deeper into the cavity pushing the contact sensor probe compressedly until the terminal reaches a stopper on the passway of the cavity of the electrical housing causing contact of another end portion of the sensor probe to take another contact to an adjacent electrical contact point.

(5) The second indication circuit is made with illumination of a lamp indiating completion of the terminal insertion accompanied by its locking engagement in the specific cavity member of the electrical connector housing.

4

Finally, the following is a list of reference numerals and elements, respectively, used in the foregoing description :

1.  case cylinder
2.  contact sensor probe
2a. first contact spindle
2b. second contact spindle
2c. flange
3.  electrical contact menber
3a. outer end portion
3b. inner contact point
4.  first electrical circuit
5.  second electrical circuit
5a. circuit end
5b. circuit end
6.  bearing
7.  insultating material
8.  coil spring
9a. indication lamp
9b. indication lamp
10. electric power source
11. electric lead wire

20. first connector housing
21. cavity
22. electrical terminal (male)
23. electric lead wire
24. electrical terminal (female)
25. mating housing member

30. second connector housing
31. cavity
31a. front surface
32. electrical terminal (male)
32a. front surface
33. passway
34. opening
35. resilient arm
36. projection
37. stopper

## Claims

1. A device for detecting the correct placement of an electric terminal (32) in a cavity (31) of an electric connector housing (30), *characterized by comprising* :
a contact sensor probe (2) of electro-conductive material, located between the front end (32a) of the inserted electric terminal (32) and an electrical contact member (3), wherein the initial touching contact of said contact sensor probe (2) with the inserted electric terminal (32) inside said cavity (31) is detected and indicated by a first circuit (4) and wherein the establishment of contact of said contact sensor probe (2) to said electrical contact member (3) indicates that the electric terminal (32) has been moved sufficiently for it to be considered correctly placed inside its housing, said establishment of contact is detected by a second circuit (5), wherein furthermore means are provided for indicating the result of the respective detections by illuminating electric lamp(s).

2. The device according to claim 1, wherein said contact sensor probe (2) includes first (2a) and second (2b) contact spindles and a flange portion (2c), wherein said contact sensor probe (2) is placed in a cylindrical case (1), being supported there by said flange (2c) and a bearing of a thrust type, and wherein further a coil spring (8) is fitted between said bearing and said flange, so that one of said spindles will meet with the electrical contact point (3b) compressedly, as the insertion of said electric terminal (32) into said connector housing (30) proceeds.

3. The device according to claim 1, wherein said contact sensor probe (2) has a direct electrical contact to said cylindrical case (1) of electro-conductive material, whereas said electrical contact point (3b) is electrically insulated from said cylindrical case (1) by means of an electrical insulating material (7).

4. The device according to claim 1, wherein a distance X of the contact spindle (2) which is facing the front end (32a) of the electric terminal (32) inside said cavity (31) is given by the following equations :

$$a + b < X \leq c \dots \dots \dots \dots \dots (1)$$
$$c < d \dots \dots \dots \dots \dots \dots (2)$$

where

$\underline{a}$ is a sensor contact clearance, which means a distance between said contact sensor probe (2) and said electrical contact point (3b) ;

$\underline{b}$ is a stop clearance, which means a distance between the opening of the cavity (31) of said connector housing (30) and the front surface (32a) of the terminal (32) at its final state of insertion along the cavity passway ;

$\underline{c}$ is the initial lock distance, which means a distance between the front surface (32a) of the inserted electric terminal (32) and the opening of the cavity (31) inside said connector housing ; and

$\underline{d}$ is a mating distance, which means a movable gap for the mated (locked) terminal.

## Patentansprüche

1. Eine Vorrichtung zur Erkennung der korrekten Anordnung eines elektrischen Anschlusses (32) in einem Hohlraum (31) eines elektrischen Steckverbindergehäuses, gekennzeichnet durch :
eine Kontaktsensorsonde (2) aus elektrisch leitfähigem Material, welche zwischen dem Vorderende (32a) des eingeführten elektrischen Anschlusses (32) und einem elektrischen Kontaktteil (3) angeordnet ist, wobei der anfängliche Berührkontakt der Kontaktsensorsonde (2) mit dem eingeführten elektrischen Anschluß (32) innerhalb des Hohlraums (31) durch einen ersten Schaltkreis (4) detektiert und angezeigt wird und wobei das Errichten eines Kontaktes der Kontaktsensorsonde (2) mit dem elektrischen Kontaktteil (3) anzeigt, daß der elektrische Anschluß (32) ausreichend weit bewegt wurde, so daß seine korrekte Anordnung innerhalb seines Gehäuses angenommen werden kann, wobei das Errichten des Kontaktes von einem zweiten Schaltkreis (5) detektiert wird, wobei weiterhin Vorrichtungen vorgesehen sind, um das Ergebnis der jeweiligen Detektionen durch Aufleuchtenlassen einer elektrischen Lampe oder elektrischer Lampen anzuzeigen.

2. Die Vorrichtung nach Anspruch 1, wobei die Kontaktsensorsonde (2) erste (2a) und zweite (2b) Kontaktspindeln und einen Flanschbereich (2c) aufweist, wobei die Kontaktsensorsonde (2) in einem zylindrischen Gehäuse (1) angeordnet ist, dort durch den Flansch (2c) und ein Drucklager gestützt ist und wobei weiterhin eine Schraubenfeder (8) zwischen das Lager und den Flansch eingesetzt ist, so daß eine der Spindeln unter Druck mit dem elektrischen Kontaktpunkt (3b) zusammentrifft, während das Einführen des elektrischen Anschlusses (32) in das Steckverbindergehäuse (30) fortschreitet.

3. Die Vorrichtung nach Anspruch 1, worin die Kontaktsensorsonde (2) direkten elektrischen Kontakt zu dem zylindrischem Gehäuse (1) aus elektrisch leitfähigem Material hat, wohingegen der elektrische Kontaktpunkt (3b) elektrisch von dem zylindrischen Gehäuse (1) mittels eines elektrisch isolierenden Materials (7) isoliert ist.

4. Die Vorrichtung nach Anspruch 1, worin eine Distanz X der Kontaktspindel (2), welche dem Vorderende (32a) des elektrischen Anschlusses (32) innerhalb des Hohlraums (31) gegenüberliegt durch die folgenden Gleichungen gegeben ist :

$$a + b < X \leq c \dots \dots \dots \dots \dots (1)$$
$$c < d \dots \dots \dots \dots \dots \dots (2),$$

wobei

$\underline{a}$ ein Sensorkontaktabstand ist, was eine Distanz zwischen der Kontaktsensorsonde (2) und dem elektrischen Kontaktpunkt (3b) bedeutet ;

$\underline{b}$ ein Anschlagabstand ist, was eine Distanz zwischen der Öffnung des Hohlraums (31) des Steckverbindergehäuses (30) und der vorderen Oberfläche (32a) des Anschlusses (32) im abschließenden Einführzustand entlang der Führung im Hohlraum bedeutet ;

c̲ die anfängliche Verriegelungsdistanz ist, was eine Distanz zwischen der vorderen Oberfläche (32a) des eingeführten elektrischen Anschlusses (32) und der Öffnung des Hohlraums (31) innerhalb des Steckverbindergehäuses bedeutet ; und

d̲ eine Paßdistanz ist, was einen beweglichen Spalt für den eingepaßten (verriegelten) Anschluß bedeutet.

## Revendications

1. Dispositif pour détecter le positionnement convenable d'un élément de raccordement électrique (32) dans une cavité (31) du corps (30) d'un connecteur électrique, caractérisé en ce qu'il comprend :
un palpeur de contact (2) en matériau conducteur électrique, situé entre l'extrémité avant (32a) de l'élément de raccordement (32) introduit dans la cavité et une pièce de contact électrique (3), le dispositif étant agencé de manière que le premier contact d'attouchement du palpeur (2) avec l'élément de raccordement (32) introduit dans la cavité (31) soit détecté et indiqué par un premier circuit (4) et de manière que l'établissement du contact entre le palpeur (2) et la pièce de contact (3) indique que l'élément de raccordement (32) a été déplacé suffisamment pour qu'il puisse être considéré comme étant positionné convenablement dans son logement, l'établissement du contact entre le palpeur (2) et la pièce de contact (3) étant détecté par un second circuit (5), le dispositif comprenant en outre des moyens pour indiquer le résultat des détections par l'allumage d'une ou de plusieurs lampes électriques.

2. Dispositif selon la revendication 1, dans lequel le palpeur (2) possède une première (2a) et une seconde (2b) broche de contact et une partie (2c) formant un collet, dans lequel le palpeur (2) est disposé dans un boîtier cylindrique (1), où il est supporté au moyen du collet (2c) et d'un appui formant butée, et dans lequel un ressort hélicoïdal (8) est placé en outre entre cet appui et ce collet, l'agencement étant tel que l'une des broches du palpeur viendra s'appliquer contre une pointe de contact électrique (3b) de la pièce de contact (3) pendant la poursuite de l'introduction de l'élément de raccordement (32) dans le corps (30) du connecteur, avec compression du ressort hélicoïdal (8).

3. Dispositif selon la revendication 1, dans lequel le palpeur (2) est en contact électrique direct avec le boîtier cylindrique (1) en matériau conducteur électrique, tandis que la pointe de contact (3b) de la pièce de contact (3) est isolée électriquement du boîtier cylindrique (1) par un matériau électriquement isolant (7).

4. Dispositif selon la revendication 1, dans lequel la distance X de pénétration dans la cavité (31) de la broche de contact (2b) faisant face à l'extrémité avant (32a) de l'élément de raccordement (32), doit correspondre aux équations suivantes :

$$a + b < X \le c \ \ldots\ldots\ldots\ldots\ldots\ldots \ (1)$$
$$c < d \ \ldots\ldots\ldots\ldots\ldots\ldots\ldots \ (2)$$

où

a̲ est l'écartement des contacts du palpeur, c'est-à-dire la distance entre le palpeur (2) et la pointe de contact (3b) de la pièce de contact ;

b̲ est une garde de butée, c'est-à-dire la distance entre l'ouverture de la cavité (31) du corps (30) du connecteur et la face avant (32a) de l'élément de raccordement (32) à sa position finale d'introduction dans le passage défini par la cavité ;

c̲ est la distance initiale de verrouillage, c'est-à-dire la distance à laquelle se trouve la face avant (32a) de l'élément de raccordement (32) introduit dans la cavité par rapport à l'ouverture de la cavité (31), du corps du connecteur ; et

d̲ est un jeu de verrouillage, c'est-à-dire l'intervalle dans lequel l'élément de raccordement peut être verrouillé.

# Fig. 1

# Fig. 2

# Fig. 3

Fig . 4

Fig . 5